# FASCICULE DE BREVET EUROPEEN

(11) **EP 3 602 640 B1**
(45) Date de publication et mention de la délivrance du brevet: **24.07.2024**
(21) Numéro de dépôt: 18711346.9
(22) Date de dépôt: 19.03.2018
(51) Int. Cl.: H01L 33/24, H01L 33/42, H01L 33/16, H01L 33/08, H01L 33/32, H01L 33/34, H01L 33/00

(54) **STRUCTURE À NANOFILS ET PROCÉDÉ DE RÉALISATION D'UNE TELLE STRUCTURE**
NANODRAHTSTRUKTUR UND VERFAHREN ZU IHRER HERSTELLUNG
NANOWIRE STRUCTURE AND MANUFACTURING METHOD THEREOF

(30) Priorité: 20.03.2017 FR 1752286
(43) Date de publication de la demande: 05.02.2020
(73) Titulaire: Commissariat à l'Énergie Atomique et aux Énergies Alternatives, 75015 Paris (FR)
(72) Inventeur: DAUDIN, Bruno, 38700 La Tronche (FR); DELAUNAY, Marc, 38240 Meylan (FR)
(74) Mandataire: Novaimo
(86) Numéro de dépôt international: PCT/EP2018/056881
(87) Numéro de publication internationale: WO 2018/172281

(56) Documents cités:
- EP-A2- 2 259 344
- WO-A1-2013/165135
- WO-A1-2017/009394
- FR-A1- 2 984 599
- FR-A1- 2 988 904
- FR-A1- 3 007 574
- KR-B1- 101 338 148
- KR-B1- 101 338 148
- US-A1- 2011 147 786
- US-A1- 2015 155 443

## Description

L'invention concerne un procédé de réalisation d'une structure à nanofils. L'invention concerne encore une structure obtenue par la mise en oeuvre du procédé de réalisation.

L'invention se rapporte en particulier au domaine des diodes électroluminescentes (LEDs). Ces diodes peuvent émettre sur une gamme d'émission s'étendant du visible à l'ultraviolet. Plus précisément l'invention se rapporte à la famille des LEDs à nanofils mais peut également s'appliquer à d'autres dispositifs à nanostructures. De façon générale, l'invention se rapporte à toute LED ou à tout dispositif constitué d'une, de quelques ou d'un ensemble de nanostructures tridimensionnelles, non coalescées, déposées ou gravées sur un substrat.

Le document KR 101 338 148 B1 divulgue un procédé de réalisation d'une structure comprenant une membrane d'un premier matériau en contact avec des extrémités de réception d'une pluralité de nanofils.

Dans ce domaine, il existe un problème de réalisation d'un contact électrique sur les nanostructures. En effet, il est nécessaire de réaliser des contacts électriques entre une électrode et les sommets des nanostructures. Il faut donc assurer un contact électrique avec un grand nombre de nanostructures (typiquement 10⁸ à 10¹⁰ contacts par cm²) tout en assurant le passage homogène du courant et en évitant tout court-circuit entre les sommets et les bases des nanostructures.

Il a été imaginé de réaliser ces contacts électriques en déposant sur les sommets des nanostructures une couche barrière, suffisante pour éviter qu'une couche métallique qui serait déposée ultérieurement sur la couche barrière cause des courts-circuits. La couche barrière doit par ailleurs être suffisamment mince ou conductrice pour permettre le passage du courant électrique. Pour ce faire, il a été envisagé d'utiliser du graphène pour réaliser la couche barrière. Ainsi, on dépose d'abord une monocouche de graphène sur les sommets des nanostructures avant de déposer ensuite une couche supplémentaire sur la couche barrière pour former une électrode. Cependant, des problèmes demeurent : en premier lieu, la conduction électrique du graphène n'a rien de spontané et la couche de graphène doit être très mince pour que le courant puisse passer par effet tunnel. Ensuite, dans le cas d'une couche très mince de graphène il se pose un problème de résistance mécanique de la couche, surtout si on souhaite que celle-ci s'étende sur une grande surface.

Le but de l'invention est de remédier aux inconvénients cités précédemment et d'améliorer les procédés de réalisation des structures à nanofils qui doivent être électriquement connectés. En particulier, l'invention propose un procédé permettant de réaliser de manière fiable des structures à nanofils électriquement connectés.

Selon l'invention, le procédé de réalisation d'une structure est défini par la revendication 1.

Le procédé peut comprendre une étape de dépôt d'une couche d'un deuxième matériau électriquement conducteur sur la membrane, notamment une étape de dépôt d'une couche d'un deuxième matériau identique au premier matériau.

La membrane peut être transparente et électriquement conductrice et/ou la membrane peut être destinée à former une électrode et/ou les nanofils peuvent être des structures de diodes électroluminescentes.

Le procédé peut comprendre une étape de réalisation du dispositif de membrane comprenant les étapes suivantes :
- Fournir un deuxième substrat, notamment une plaquette en silicium ;
- Déposer, sur le deuxième substrat, une couche sacrificielle, notamment de métal, en particulier de nickel ou de cuivre,
- Déposer, sur la couche sacrificielle, une couche de premier matériau, notamment une couche d'environ 30 nm d'épaisseur,
- Déposer, sur la couche de premier matériau, une couche de résine,
- Attaquer chimiquement la couche sacrificielle, par exemple avec une solution de FeCl₃.

Suite à l'étape de mise en place du dispositif de membrane sur les nanofils au niveau des extrémités de réception, on rince la structure avec un solvant de manière à dissoudre une couche du dispositif de membrane, en particulier de manière à dissoudre une couche de résine du dispositif de membrane.

L'étape de conformation du dispositif à nanofils peut être mise en oeuvre par épitaxie par jets moléculaires ou par épitaxie en phase vapeur aux organométalliques ou par gravure.

L'étape de conformation peut comprendre la conformation du dispositif de sorte qu'il comprenne un premier substrat, les nanofils étant disposés sur le premier substrat, notamment les nanofils étant disposés perpendiculairement ou sensiblement perpendiculairement sur une surface du premier substrat, et/ou de sorte que les nanofils soient prismatiques ou sensiblement prismatiques et/ou de sorte que les nanofils présentent des structures de diodes électroluminescentes.

L'étape de conformation peut comprendre la conformation des extrémités de réception de sorte qu'elles forment une surface discontinue plane ou sensiblement plane.

L'étape de conformation peut comprendre la conformation du dispositif de sorte que le ratio de la somme des aires des surfaces des extrémités de réception rapporté à l'aire continue de la surface d'une membrane destinée à venir en contact avec les extrémités de réception soit supérieur à 80% ou supérieur à 90% ou supérieur à 95%.

L'étape de conformation peut comprendre la conformation de nanofils de sorte que les nanofils présentent une géométrie s'agrandissant ou s'évasant en direction des extrémités de réception et/ou l'étape de conformation peut comprendre la conformation de nanofils de sorte que les nanofils constituent des micro-piliers ou des nano-piliers incluant les extrémités de réception dont les surfaces présentent des dimensions supérieures à celles des diamètres des nanofils à distance de l'extrémité de réception.

L'étape de conformation peut comprendre la conformation de nanofils de sorte qu'ils comprennent chacun un corps et une tête, la tête présentant une extrémité de réception, la surface de l'extrémité de réception présentant une aire 20% supérieure, voire 50% supérieure, à l'aire d'une section du corps d'un nanofil, notamment à l'aire d'une section du nanofil mesurée parallèlement à l'extrémité de réception à au moins 2 µm de distance de l'extrémité de réception ou à l'aire d'une section du nanofil mesurée parallèlement à l'extrémité de réception au milieu du nanofil. L'étape de conformation peut comprendre la conformation des corps des nanofils en empilements d'une couche de GaN type n, d'une couche de InGa et d'une couche de blocage.

L'étape de conformation peut comprendre la conformation des têtes des nanofils en empilements d'une couche de GaN type p et d'une couche de GaN type p++.

L'étape de conformation peut comprendre la conformation des nanofils en matériau à base de silicium.

Dans un mode de réalisation qui n'est pas selon l'invention, une structure, notamment une diode électroluminescente à nanofils, est obtenue par la mise en oeuvre du procédé de réalisation défini précédemment.

Les objets, caractéristiques et avantages de la présente invention sont exposés en détail dans la description suivante d'un mode de réalisation d'un dispositif et d'un mode d'exécution d'un procédé de réalisation d'une structure. Ces modes de réalisation et d'exécution sont non limitatifs. Le dessin annexé est composé comme suit :
La figure 1 est une vue en perspective d'un mode de réalisation d'une structure comprenant des nanofils.
La figure 2 est une vue schématique d'une première variante de réalisation d'un nanofil.
La figure 3 est une vue schématique d'une deuxième variante de réalisation d'un nanofil.
Les figures 4 à 9 sont des vues schématiques illustrant un mode d'exécution d'un procédé de réalisation d'une structure à nanofils selon l'invention.
La figure 10 est une vue schématique de dessus du mode de réalisation de la structure.

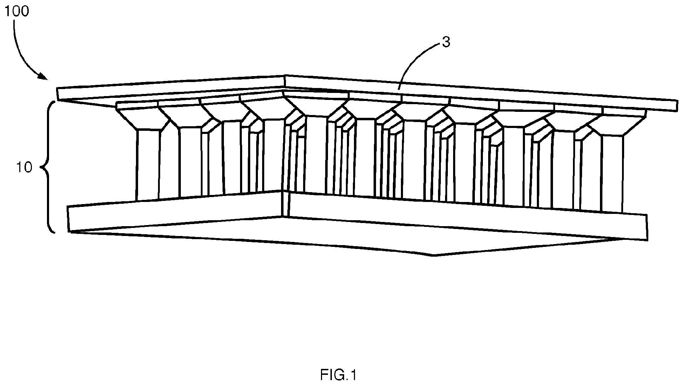

Un mode de réalisation d'une diode électroluminescente 100 à nanofils est décrit ci-après en référence à la figure 1.

La diode comprend une structure à nanofils. La structure comprend un dispositif 10 à nanofils et une membrane 3 en un premier matériau, notamment de l'oxyde d'indium-étain.

Avantageusement, les nanofils ont des structures de diodes électroluminescentes.

La membrane recouvre le dispositif à nanofils. La membrane recouvre en particulier les extrémités des nanofils, dites extrémités de réception de la membrane ou extrémités de réception. Les nanofils sont non coalescés. Les extrémités de réception forment une surface discontinue.

Par « surface discontinue », on entend par exemple que les extrémités de réception ne se touchent pas. En particulier, on entend qu'au moins certaines surfaces de réception sont disposées à distance des autres surfaces de réception voisines. De préférence, on entend que chaque surface de réception est disposée à distance des autres surfaces de réception voisines.

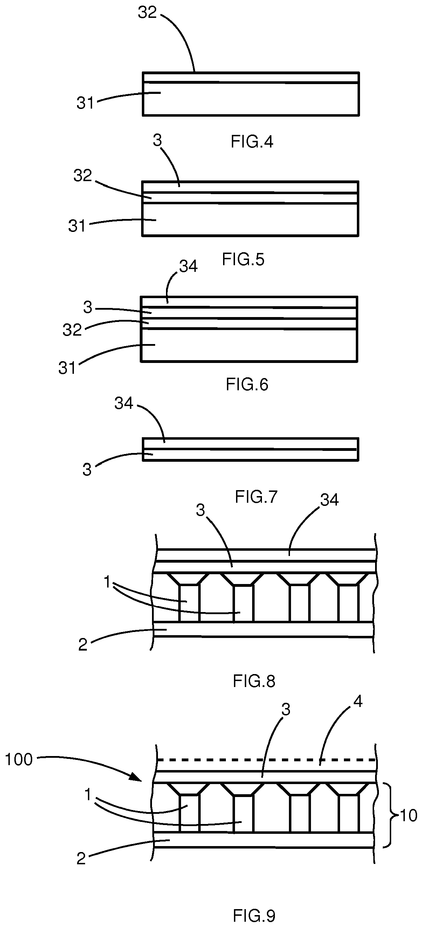

Optionnellement, la structure 100 peut comprendre une couche 4 d'un deuxième matériau électriquement conducteur, notamment un deuxième matériau identique au premier matériau. Cette couche recouvre alors la membrane 3 comme représenté sur la figure 9.

De préférence, la membrane est électriquement conductrice. En effet, elle est destinée à servir d'électrode d'injection de courant dans les nanofils ou d'électrode d'application d'un potentiel sur les nanofils. Dans le cas d'une structure de diode électroluminescente, la membrane est avantageusement transparente.

La membrane reportée doit être assez mince et/ou assez souple pour épouser correctement les surfaces des extrémités de réception des nanofils.

Le dispositif 10 comprend au moins un nanofil. De préférence, le dispositif 10 comprend une pluralité de nanofils. Ces nanofils sont par exemple répartis selon un motif, chacun à distance des autres. Les nanofils sont non coalescés. Les extrémités de réception forment une surface discontinue. Par exemple, les nanofils sont disposés sur un substrat 2 selon plusieurs rangées successives.

Les nanofils peuvent être disposés les uns derrière les autres selon des rangées. Ainsi, des lignes de nanofils sont orientées perpendiculairement aux rangées de nanofils. Alternativement, les nanofils peuvent être disposés en quinconce, chaque nanofil d'une rangée suivante étant disposé entre deux nanofils d'une rangée précédente. Alternativement encore, les nanofils peuvent aussi être disposés plus aléatoirement.

Avantageusement, les nanofils présentent une géométrie s'agrandissant ou s'évasant en direction des extrémités de réception. De préférence encore, les nanofils constituent des micro-piliers ou des nano-piliers incluant les extrémités de réception dont les surfaces présentent des dimensions supérieures à celles des diamètres des nanofils à distance de l'extrémité de réception.

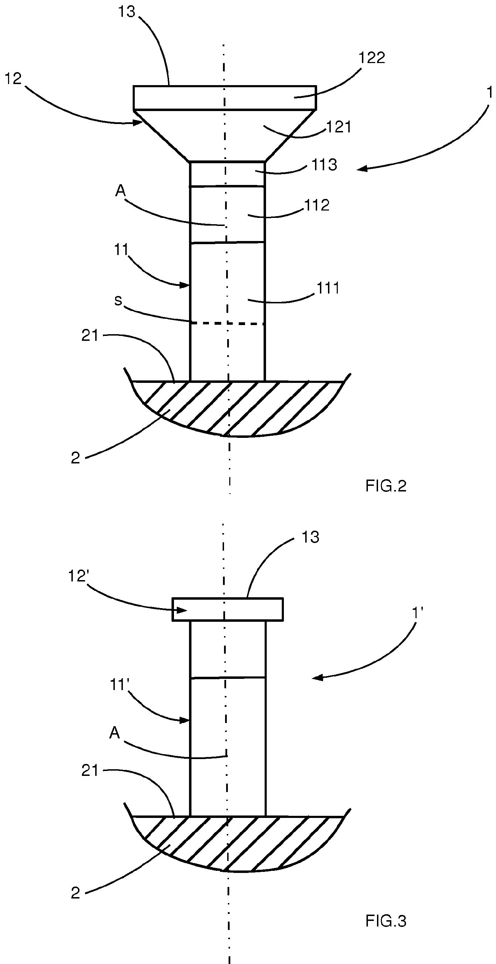

Comme illustré sur les figures 2 et 3, au moins un nanofil, préférentiellement certains nanofils, préférentiellement encore tous les nanofils, comprennent chacun un corps 11 ; 11' et une tête 12 ; 12'. Par « nanofil », nous entendons, de préférence, dans tout ce document, toute structure s'étendant principalement selon une direction A ou selon une courbe et présentant une dimension transversale à cette direction ou à cette courbe de l'ordre d'un micromètre ou inférieure à un micromètre. De préférence encore, toutes les dimensions de la structure mesurées transversalement à la direction A ou à la courbe sont de l'ordre d'un micromètre ou inférieures à un micromètre.

De préférence, les nanofils sont disposés perpendiculairement ou sensiblement perpendiculairement sur une surface 21 du substrat 2. Ainsi, une direction A ou une courbe selon laquelle les nanofils s'étendent au niveau de la surface 21 est perpendiculaire ou sensiblement perpendiculaire à cette surface 21.

La surface 21 est une surface plane. Alternativement, la surface peut être une surface réglée non plane, voire une surface gauche.

Les nanofils sont de préférence prismatiques ou sensiblement prismatiques, en particulier en forme de prismes droits. Par exemple, les nanofils peuvent être à section hexagonale. Toutefois, les nanofils peuvent présenter toute autre forme de section.

De préférence, tous les nanofils sont similaires ou identiques.

Les corps relient la surface 21 du substrat 2 aux têtes de nanofils.

Dans la variante représentée du premier mode de réalisation de la structure de diode électroluminescente, les nanofils présentent une hétérostructure de type axial telle que représentée sur la figure 2. Selon cette variante, le corps comprend un empilement d'une couche 111 de GaN type n, d'une couche 112 d'InGa et d'une couche de blocage 113. La couche 111 est en contact avec la surface 21 du substrat. La couche 112 est en contact avec la couche 111. La couche 113 est en contact avec la couche 112 et avec la tête.

Les têtes sont en contact avec les corps, notamment en contact avec les extrémités des corps qui ne sont pas en contact avec la surface 21.

Les extrémités des têtes opposées aux extrémités en contact avec les corps présentent des extrémités de réception 13. Ces extrémités de réception forment des surfaces libres à l'issue de la phase de conformation des nanofils. Ces extrémités de réception sont destinées à recevoir la membrane 3 lors d'une étape ultérieure de réalisation de la structure 100.

De préférence, les surfaces des extrémités de réception sont planes ou sensiblement planes. Elles peuvent toutefois présenter une certaine courbure concave ou convexe. Par exemple, la surface d'une extrémité de réception d'un nanofil est considérée comme plane si son rayon de courbure minimum est égal ou supérieur à la hauteur du corps du nanofil.

Les surfaces des extrémités de réception présentent une aire sensiblement supérieure à l'aire d'une section s du corps du nanofil, par exemple au moins 20% supérieure, voire au moins 50% supérieure. Notamment, la section s considérée du corps du nanofil est positionnée parallèlement à l'extrémité de réception ou perpendiculairement à l'axe A. De plus, de préférence, la section s considérée est positionnée à au moins 2 µm de distance de l'extrémité de réception. Par exemple, la section s considérée du nanofil est parallèle à l'extrémité de réception au milieu du nanofil ou au milieu du corps du nanofil. Ainsi, l'aire des nanofils en contact avec la membrane est significativement supérieure à l'aire projetée de la base des nanofils (perpendiculairement à la direction A selon laquelle s'étend les nanofils). Par exemple, l'aire des nanofils en contact avec la membrane peut être supérieure à 10 fois l'aire projetée de la base des nanofils.

De préférence, on discrimine la tête du corps par une variation d'au moins une dimension mesurée transversalement à la direction A selon laquelle s'étend le nanofil. Dans ce cas, la limite entre le corps et la tête peut par exemple être définie par une augmentation d'une dimension transversale du corps significative, notamment une augmentation de plus de 10%. Plus généralement, la tête présente au moins une dimension transversale supérieure à une dimension transversale du corps.

Dans le mode de réalisation représenté sur les figures 1, 2 et 4 à 10, les têtes sont tronconiques à section polygonale ou comprennent un tronc de cône à section polygonale. La petite base du tronc de cône est en contact avec le corps.

Dans l'hypothèse d'une réalisation des nanofils par épitaxie par jets moléculaires, un choix judicieux des conditions de croissance des nanofils permet d'obtenir une tête élargie, notamment en forme de tronc de cône à section polygonale.

Dans le mode de réalisation décrit en référence aux figures 1 et 2, les têtes sont des empilements d'une couche 121 de GaN type p et d'une couche 122 de GaN type p++. Les têtes peuvent aussi être réalisées différemment, en particulier dans d'autres exemples de réalisation, la couche 121 peut être constituée d'InGaN et surmontée d'une couche conforme ou élargie à son tour de GaN type p, elle-même surmontée d'une couche conforme ou élargie à son tour de GaN type p++. La couche 121 est par exemple tronconique à section polygonale. Une face de la couche 122 forme l'extrémité de réception.

Les différentes extrémités de réception forment une surface discontinue. En effet, entre les différentes extrémités de réception, il est possible de raccorder les surfaces des extrémités de réception pour réaliser une surface continue, notamment une surface sans discontinuité significative de courbure. La surface discontinue raccordée peut être plane ou sensiblement plane. Plus généralement, cette surface discontinue raccordée peut aussi être une surface réglée non plane ou une surface gauche. Une fois la membrane mise en place sur les extrémités de réception, la membrane permet d'assurer une continuité électrique sur la structure discontinue du dispositif à nanofils.

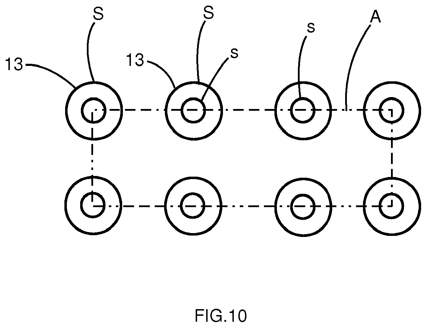

De préférence, comme représenté sur la figure 10, le ratio de la somme des aires des surfaces des extrémités de réception rapporté à l'aire totale de la surface discontinue raccordée entre les extrémités de réception est par exemple supérieur à 80% ou supérieur à 90% ou supérieur à 95%. Ainsi, une fois la membrane mise en place sur les extrémités, la membrane est en contact avec les nanofils sur plus de 80% ou plus de 90% ou plus de 95% de sa surface. Les géométries des têtes définissent donc une densité surfacique de matière contre laquelle la membrane peut venir en contact. Cette densité est très importante. Plus elle est élevée, moins il y a de risque de déchirer ou de percer la membrane en la mettant en place sur les nanofils et plus on assure un bon contact électrique entre la membrane et les nanofils.

Si la densité de présence de matière au niveau des extrémités de réception est trop faible, la membrane peut être percée, notamment en bord de structure, en raison de la finesse des nanofils et/ou de la grande distance qui les sépare. Un tel endommagement n'est bien entendu pas souhaitable. Pour s'en affranchir, la densité de présence de matière (exprimée en pourcentage plus haut) est suffisamment élevée. Pour obtenir une densité de présence de matériau élevée au niveau des extrémités de réception, on utilise un dispositif à nanofils tels que décrit précédemment. En complément ou alternativement, on peut utiliser un dispositif à densité surfacique de nanofils élevée, par exemple de l'ordre de 10¹⁰ nanofils par cm² sur la surface 21. La combinaison d'une densité élevée de nanofils et d'un dispositif à nanofils à géométrie particulière tels que décrit précédemment est favorable au report d'une membrane sans endommagement ou déchirure.

Selon l'invention, le ratio de la somme des aires des surfaces des extrémités de réception rapporté à l'aire totale de la surface discontinue raccordée entre les extrémités de réception est par exemple strictement inférieur à 100%.

Le report de la membrane peut également être réalisé dans le cas où les nanofils sont plus éloignés les uns des autres. Par exemple, la distance entre les nanofils, autrement dit le pas du réseau de nanofils, peut être supérieur(e) ou égal(e) à au moins cinq fois la dimension transversale du corps des nanofils. Le pas du réseau de nanofils sera ajusté en fonction notamment de la résistance mécanique du matériau formant la membrane.

Dans une autre variante de réalisation, les têtes des nanofils peuvent ne pas être tronconiques à section polygonale, mais peuvent avoir toute autre forme. En particulier, les têtes peuvent être prismatiques comme représenté sur la figure 3. Dans ce cas, le diamètre de la tête 12' est supérieur au diamètre du corps 11'. Dans l'hypothèse d'une réalisation des nanofils par épitaxie par jets moléculaires, un choix judicieux des conditions de croissance des nanofils permet d'obtenir une tête élargie, notamment avec une géométrie en forme de « tête de clou ».

Dans une autre variante de réalisation, les nanofils peuvent ne pas avoir une structure de diode électroluminescente. En effet, une structure à nanofils telle que décrite précédemment peut ne pas être utilisée pour émettre de la lumière. Dans d'autres applications, les nanofils peuvent notamment être réalisés en un matériau à base de silicium ou à base de tout autre matériau semiconducteur tels que ceux appartenant à la famille des arseniures ou à base de tout autre matériau (métal, polymère, céramique) sur lequel il existe intérêt à déposer une membrane permettant d'assurer la continuité d'une injection électrique et/ou de l'application d'un potentiel.

Un mode d'exécution d'un procédé selon l'invention de réalisation d'une structure 100 comprenant une membrane 3 formant électrode et une pluralité de nanofils 1 est décrit ci-après en référence aux figures 4 à 9.

Dans une première phase, selon l'invention on réalise un dispositif de membrane 3, 34, comprenant la membrane 3 recouverte d'une couche 34.

Dans une deuxième phase, on réalise ou on conforme un dispositif 10 à nanofils tel que décrit précédemment ou un dispositif à nanofils qui diffère de ce qui a été décrit précédemment en ce que les nanofils ont une structure dans laquelle on ne peut pas distinguer une tête d'un corps, c'est-à-dire par exemple une structure à dimension ou à section transversale constante ou sensiblement constante sur toute la longueur des nanofils. Les nanofils du dispositif 10 forment une structure discontinue. Les nanofils sont non coalescés, chacun à distance des autres. Les extrémités des nanofils, dites extrémités de réception de la membrane ou extrémités de réception, forment une surface discontinue.

Dans une troisième phase, on met en place le dispositif de membrane 3, 34 sur le dispositif 10 à nanofils, notamment par report. Le dispositif de membrane est mis en place directement sur les nanofils au niveau des surfaces des extrémités de réception de la membrane. Le dispositif de membrane se « colle » sur les surfaces des extrémités de réception par la force de Van der Waals. Ainsi, selon ce procédé on vient positionner le dispositif de membrane directement sur les extrémités de réception. Le dispositif de membrane est mis en place de sorte que la couche électriquement conductrice et/ou transparente du dispositif de membrane vient directement au contact des nanofils, notamment directement au contact des extrémités de réception des nanofils. Ainsi, le dispositif de membrane est mis en place sur les nanofils sans qu'il ait été disposé préalablement :
- une matière de remplissage entre les différents nanofils, ou
- une couche barrière sur les nanofils, en particulier une couche barrière reposant sur les extrémités libres des nanofils.

Dans une quatrième phase, on rince la structure avec un solvant, par exemple de l'acétone, notamment de manière à dissoudre une couche 34 du dispositif de membrane, en particulier de manière à dissoudre une couche de résine du dispositif de membrane. Dans cette quatrième phase, on peut ensuite optionnellement déposer une couche 4 d'un deuxième matériau électriquement conducteur sur la membrane 3, comme représenté sur la figure 9. Le deuxième matériau peut être identique au premier matériau. Cette étape de dépôt optionnelle permet par exemple de renforcer mécaniquement la membrane en l'épaississant.

Les première et deuxième phases peuvent être exécutées dans n'importe quel ordre. Elles peuvent aussi être exécutées en parallèle ou simultanément.

Dans la première phase, on peut mettre en oeuvre les étapes qui suivent.

Dans une première étape, on fournit un deuxième substrat 31, par exemple une plaquette en silicium.

Dans une deuxième étape, comme représenté sur la figure 4, on dépose sur le deuxième substrat une couche 32 sacrificielle, par exemple une couche de métal, en particulier une couche de nickel ou de cuivre.

Dans une troisième étape, comme représenté sur la figure 5, on dépose, sur la couche sacrificielle, une couche 3 du premier matériau, notamment par exemple une couche d'environ 30 nm d'épaisseur ou une couche d'environ 20 nm d'épaisseur. Cette couche constitue la membrane 3.

Dans une quatrième étape, comme représenté sur la figure 6, on dépose, sur la couche de premier matériau, une couche 34 de résine.

Dans une cinquième étape, comme représenté sur la figure 7, on attaque chimiquement la couche sacrificielle 32, par exemple avec une solution de FeCl₃. On obtient ainsi une membrane (formée des couches 3 et 34) comme représenté sur la figure 7.

De préférence dans la deuxième phase, on met en forme ou on réalise le dispositif 10 par exemple par épitaxie par jets moléculaires ou par épitaxie en phase vapeur aux organométalliques ou par gravure. Un choix judicieux des paramètres du processus utilisé permet d'obtenir une tête élargie. Notamment, un choix judicieux des conditions de croissance des nanofils par épitaxie par jets moléculaires permet d'obtenir une tête élargie.

Grâce au dispositif et au procédé décrits plus haut, il est possible de réaliser une électrode (transparente et conductrice) sur des micro ou nano piliers comportant chacun à son sommet une surface plane de dimension supérieure au diamètre desdits piliers. La réalisation est assurée par mise en place ou par report d'une membrane (transparente et conductrice) sur ces surfaces sommitales. La géométrie et la densité des surfaces sommitales permettent d'obtenir un contact électrique optimisé en évitant le percement éventuel de la membrane par les piliers. La membrane permet d'assurer une continuité électrique sur la structure discontinue du dispositif à nanofils.

Comme vu précédemment, une application intéressante de l'invention concerne la réalisation des structures LEDs. Il est à noter que dans le cas de LEDs organiques qui peuvent être endommagées par les techniques classiques de dépôt de couches métalliques, la solution du report est une technique douce qui permet de préserver l'intégrité d'une membrane lors de sa mise en place.

Il est en outre à noter que toute structure à éléments filaire peut être concernée par le dispositif et le procédé objet de ce document, indépendamment de la densité ou de la taille des éléments filaires. On peut ainsi envisager la prise de contact notamment sur des émetteurs de photons uniques ou sur des objets photoniques variés (microdisques).

L'utilisation de membranes conductrices reportées n'est *a priori* pas limitée au domaine des LEDs. On peut également reporter ce type de membrane sur n'importe quel type de nanofils ou nanopiliers obtenus par une technologie « bottom-up » ou « top-down ».

Le report d'une membrane en oxyde d'indium-étain ou ITO a été décrit précédemment. Cependant, outre l'ITO, n'importe quelle membrane en un autre matériau peut *a priori* être reportée, pourvu qu'elle puisse être facilement détachée du support initial, par exemple via une attaque chimique d'une couche sacrificielle.

L'invention est définie par les revendications ci-après. 11

## Revendications

1. Procédé de réalisation d'une structure (100) comprenant une membrane (3) d'un premier matériau, notamment de l'oxyde d'indium-étain, en contact avec des extrémités (13) de réception d'une pluralité de nanofils (1), le procédé comprenant les étapes suivantes :
- Conformation d'un dispositif (10) à nanofils comprenant les extrémités (13) de réception, les extrémités de réception étant conformées de sorte à former des surfaces planes,
- Réalisation d'un dispositif de membrane (3 ; 34) comprenant ladite membrane (3) et une couche (34),
- Mise en place, par report, du dispositif de membrane (3 ; 34), préalablement réalisé, directement sur les nanofils au niveau des surfaces planes des extrémités de réception, de sorte que la membrane soit en contact avec lesdites extrémités de réception, le ratio de la somme des aires des surfaces des extrémités de réception rapporté à l'aire continue de la surface de la membrane sur lesdites extrémités de réception étant strictement inférieur à 100%, et
- Suite à l'étape de mise en place du dispositif de membrane sur les nanofils au niveau des extrémités de réception, rinçage de la structure avec un solvant, de manière à dissoudre la couche (34) du dispositif de membrane de sorte à conserver sur lesdites extrémités de réception, la membrane (3).

2. Procédé selon la revendication 1, **caractérisé en ce qu'**il comprend une étape de dépôt d'une couche (4) d'un deuxième matériau électriquement conducteur sur la membrane (3), notamment une étape de dépôt d'une couche d'un deuxième matériau identique au premier matériau.

3. Procédé selon l'une des revendications précédentes, **caractérisé en ce que** la membrane est transparente et électriquement conductrice et/ou **en ce que** la membrane est destinée à former une électrode et/ou **en ce que** les nanofils sont des structures de diodes électroluminescentes.

4. Procédé selon l'une des revendications précédentes, **caractérisé en ce que** l'étape de réalisation du dispositif de membrane (3, 34) comprend les étapes suivantes :
- Fournir un deuxième substrat (31), notamment une plaquette en silicium ;
- Déposer, sur le deuxième substrat, une couche (32) sacrificielle, notamment de métal, en particulier de nickel ou de cuivre,
- Déposer, sur la couche sacrificielle, une couche (3) de premier matériau destinée à former la membrane, notamment une couche d'environ 30 nm d'épaisseur,
- Déposer, sur la couche de premier matériau, une couche (34) de résine, la membrane (3) et la couche (34) de résine formant le dispositif de membrane,
- Attaquer chimiquement la couche sacrificielle, par exemple avec une solution de FeCl₃, de sorte à détacher le dispositif de membrane, du deuxième substrat.

5. Procédé selon l'une des revendications précédentes, **caractérisé en ce que** l'étape de conformation du dispositif à nanofils est mise en oeuvre par épitaxie par jets moléculaires ou par épitaxie en phase vapeur aux organométalliques ou par gravure.

6. Procédé selon l'une des revendications précédentes, **caractérisé en ce que** l'étape de conformation comprend la conformation du dispositif de sorte qu'il comprenne un premier substrat (2), les nanofils étant disposés sur le premier substrat, notamment les nanofils étant disposés perpendiculairement ou sensiblement perpendiculairement sur une surface (21) du premier substrat, et/ou de sorte que les nanofils soient prismatiques ou sensiblement prismatiques et/ou de sorte que les nanofils présentent des structures de diodes électroluminescentes.

7. Procédé selon l'une des revendications précédentes, **caractérisé en ce que** l'étape de conformation comprend la conformation des extrémités de réception de sorte qu'elles forment une surface discontinue plane ou sensiblement plane.

8. Procédé selon la revendication précédente, **caractérisé en ce que** l'étape de conformation comprend la conformation du dispositif de sorte que le ratio de la somme des aires des surfaces des extrémités de réception rapporté à l'aire continue de la surface d'une membrane destinée à venir en contact avec les extrémités de réception soit supérieur à 80% ou supérieur à 90% ou supérieur à 95%.

9. Procédé selon l'une des revendications précédentes, **caractérisé en ce que** l'étape de conformation comprend la conformation de nanofils de sorte que les nanofils présentent une géométrie s'agrandissant ou s'évasant en direction des extrémités de réception et/ou **en ce que** l'étape de conformation comprend la conformation de nanofils de sorte que les nanofils constituent des micro-piliers ou des nano-piliers incluant les extrémités de réception dont les surfaces présentent des dimensions supérieures à celles des diamètres des nanofils à distance de l'extrémité de réception.

10. Procédé selon l'une des revendications précédentes, **caractérisé en ce que** l'étape de conformation comprend la conformation de nanofils de sorte qu'ils comprennent chacun un corps (11 ; 11') et une tête (12 ; 12'), la tête présentant une extrémité de réception (13), la surface de l'extrémité de réception présentant une aire 20% supérieure, voire 50% supérieure, à l'aire d'une section (s) du corps d'un nanofil, notamment à l'aire d'une section (s) du nanofil mesurée parallèlement à l'extrémité de réception à au moins 2 µm de distance de l'extrémité de réception ou à l'aire d'une section (s) du nanofil mesurée parallèlement à l'extrémité de réception au milieu du nanofil.

11. Procédé selon la revendication précédente, **caractérisé en ce que** l'étape de conformation comprend la conformation des corps des nanofils en empilements d'une couche (111) de GaN type n, d'une couche (112) d'InGaN et d'une couche de blocage (113).

12. Procédé selon l'une des revendications 10 et 11, **caractérisé en ce que** l'étape de conformation comprend la conformation des têtes des nanofils en empilements d'une couche (121) de GaN type p et d'une couche (122) de GaN type p++.

13. Procédé selon l'une des revendications 1 à 10, **caractérisé en ce que** l'étape de conformation comprend la conformation des nanofils en matériau à base de silicium.

## Patentansprüche

1. Verfahren zur Herstellung einer Struktur (100), die eine Membran (3) aus einem ersten Material, insbesondere Indiumzinnoxid, in Kontakt mit Empfangsenden (13) einer Vielzahl von Nanodrähten (1) enthält, wobei das Verfahren die folgenden Schritte enthält:
- Gestaltung einer Vorrichtung (10) mit Nanodrähten, die die Empfangsenden (13) enthält, wobei die Empfangsenden so gestaltet sind, dass sie ebene Flächen bilden,
- Herstellung einer Membranvorrichtung (3; 34), die die Membran (3) und eine Schicht (34) enthält,
- Einsetzen, durch Verschiebung, der vorher hergestellten Membranvorrichtung (3; 34) direkt auf die Nanodrähte im Bereich der ebenen Flächen der Empfangsenden, so dass die Membran mit den Empfangsenden in Kontakt ist, wobei das Verhältnis der Summe der Flächeninhalte der Flächen der Empfangsenden bezogen auf den kontinuierlichen Flächeninhalt der Fläche der Membran auf den Empfangsenden strikt niedriger als 100% ist, und
- nach dem Schritt des Einsetzens des Membranvorrichtung auf die Nanodrähte im Bereich der Empfangsenden, Spülen der Struktur mit einem Lösungsmittel, um die Schicht (34) der Membranvorrichtung aufzulösen, um die Membran (3) auf den Empfangsenden zu behalten.

2. Verfahren nach Anspruch 1, **dadurch gekennzeichnet, dass** es einen Schritt des Abscheidens einer Schicht (4) eines zweiten elektrisch leitenden Materials auf die Membran (3) enthält, insbesondere einen Schritt des Abscheidens einer Schicht eines zweiten Materials gleich dem ersten Material.

3. Verfahren nach einem der vorhergehenden Ansprüche, **dadurch gekennzeichnet, dass** die Membran transparent und elektrisch leitend ist und/oder dass die Membran dazu bestimmt ist, eine Elektrode zu bilden, und/oder dass Nanodrähte Strukturen von Elektrolumineszenzdioden sind.

4. Verfahren nach einem der vorhergehenden Ansprüche, **dadurch gekennzeichnet, dass** der Schritt der Herstellung der Membranvorrichtung (3, 34) die folgenden Schritte enthält:
- Bereitstellen eines zweiten Substrats (31), insbesondere eines Siliciumplättchens;
- Abscheiden einer Opferschicht (32), vor allem von Metall, insbesondere von Nickel oder Kupfer, auf das zweite Substrat,
- Abscheiden einer Schicht (3) eines ersten Materials, die dazu bestimmt ist, die Membran zu bilden, auf die Opferschicht, insbesondere einer Schicht von etwa 30 nm Dicke,
- Abscheiden einer Harzschicht (34) auf die Schicht eines ersten Materials, wobei die Membran (3) und die Harzschicht (34) die Membranvorrichtung bilden,
- Chemisches Ätzen der Opferschicht, zum Beispiel mit einer Lösung von FeCl₃, um die Membranvorrichtung vom zweiten Substrat zu lösen.

5. Verfahren nach einem der vorhergehenden Ansprüche, **dadurch gekennzeichnet, dass** der Schritt der Gestaltung der Vorrichtung mit Nanodrähten durch Molekularstrahlepitaxie oder durch metallorganische Gasphasenepitaxie oder durch Ätzen durchgeführt wird.

6. Verfahren nach einem der vorhergehenden Ansprüche, **dadurch gekennzeichnet, dass** der Schritt der Gestaltung die Gestaltung der Vorrichtung derart enthält, dass sie ein erstes Substrat (2) enthält, wobei die Nanodrähte auf dem ersten Substrat angeordnet sind, wobei vor allem die Nanodrähte lotrecht oder im Wesentlichen lotrecht auf einer Fläche (21) des ersten Substrats angeordnet sind, und/oder dass die Nanodrähte prismatisch oder im Wesentlichen sind und/oder dass die Nanodrähte Strukturen von Elektrolumineszenzdioden aufweisen.

7. Verfahren nach einem der vorhergehenden Ansprüche, **dadurch gekennzeichnet, dass** der Schritt der Gestaltung die Gestaltung der Empfangsenden derart enthält, dass sie eine ebene oder im Wesentlichen ebene diskontinuierliche Fläche bilden.

8. Verfahren nach dem vorhergehenden Anspruch, **dadurch gekennzeichnet, dass** der Schritt der Gestaltung die Gestaltung der Vorrichtung derart enthält, dass das Verhältnis der Summe der Flächeninhalte der Flächen der Empfangsenden bezogen auf den kontinuierlichen Flächeninhalt der Fläche einer Membran, die dazu bestimmt ist, mit den Empfangsenden in Kontakt zu kommen, größer ist als 80% oder größer als 90% oder größer als 95%.

9. Verfahren nach einem der vorhergehenden Ansprüche, **dadurch gekennzeichnet, dass** der Schritt der Gestaltung die Gestaltung von Nanodrähten derart enthält, dass die Nanodrähte eine Geometrie aufweisen, die sich in Richtung der Empfangsenden vergrößert oder ausweitet und/oder dass der Schritt der Gestaltung die Gestaltung von Nanodrähten derart enthält, dass die Nanodrähte Mikrosäulen oder Nanosäulen bilden, die die Empfangsenden umfassen, deren Flächen Abmessungen größer als diejenigen der Durchmesser der Nanodrähte in Abstand zum Empfangsende aufweisen.

10. Verfahren nach einem der vorhergehenden Ansprüche, **dadurch gekennzeichnet, dass** der Schritt der Gestaltung die Gestaltung von Nanodrähten derart enthält, dass sie je einen Körper (11; 11') und einen Kopf (12; 12') enthalten, wobei der Kopf ein Empfangsende (13) aufweist, wobei die Fläche des Empfangsendes einen Flächeninhalt aufweist, der 20% größer, sogar 50% größer ist als der Flächeninhalt eines Querschnitts (s) des Körpers eines Nanodrahts, vor allem als der Flächeninhalt eines Querschnitts (s) des Nanodrahts gemessen parallel zum Empfangsende in mindestens 2 µm Abstand zum Empfangsende oder als der Flächeninhalt eines Querschnitts (s) des Nanodrahts gemessen parallel zum Empfangsende in der Mitte des Nanodrahts.

11. Verfahren nach dem vorhergehenden Anspruch, **dadurch gekennzeichnet, dass** der Schritt der Gestaltung die Gestaltung der Körper der Nanodrähte in Stapeln einer Schicht (111) von GaN vom n-Typ, einer Schicht (112) von InGaN und einer Sperrschicht (113) enthält.

12. Verfahren nach einem der Ansprüche 10 und 11, **dadurch gekennzeichnet, dass** der Schritt der Gestaltung die Gestaltung der Köpfe der Nanodrähte in Stapeln einer Schicht (121) von GaN vom p-Typ und einer Schicht (122) von GaN vom p++-Typ enthält.

13. Verfahren nach einem der Ansprüche 1 bis 10, **dadurch gekennzeichnet, dass** der Schritt der Gestaltung die Gestaltung der Nanodrähte aus einem Material auf der Basis von Silicium enthält.

## Claims

1. A process for producing a structure (100) comprising a membrane (3) of a first material, in particular indium-tin oxide, in contact with receiving ends (13) of a plurality of nanowires (1), the process comprising the following steps:
- Forming a nanowire device (10) comprising the receiving ends (13), the receiving ends being formed so as to form planar surfaces,
- Producing of a membrane device (3 ; 34) comprising said membrane (3) and a layer (34)
- Placing, by transfer, of the membrane device (3; 34), previously made, directly on the nanowires at the planar surfaces of the receiving ends, so that the membrane is in contact with said receiving ends, the ratio of the sum of the areas of the surfaces of the receiving ends relative to the continuous area of the surface of the membrane on said receiving ends being strictly less than 100%, and
- Following the step of placing the membrane device on the nanowires at the receiving ends, rinsing the structure with a solvent, so as to dissolve the layer (34) of the membrane device so as to remain on said receiving ends, the membrane (3).

2. The process as claimed in claim 1, **characterized in that** it comprises a step of depositing a layer (4) of an electrically conductive second material on the membrane (3), especially a step of depositing a layer of a second material identical to the first material.

3. The process as claimed in one of the preceding claims, **characterized in that** the membrane is transparent and electrically conductive and/or **in that** the membrane is intended to form an electrode and/or **in that** the nanowires are light-emitting-diode structures.

4. The process as claimed in one of the preceding claims, **characterized in that** the step of producing the membrane device (3, 34), comprises the following steps:
- Providing a second substrate (31), especially a silicon wafer,
- Depositing, on the second substrate, a sacrificial layer (32), especially a metal sacrificial layer and in particular a nickel or copper sacrificial layer,
- Depositing, on the sacrificial layer, a layer (3) of first material intended to form the membrane, especially a layer of about 30 nm thickness,
- Depositing, on the layer of first material, a resin layer (34), the membrane (3) and the resin layer (34) forming the membrane device
- Chemically attacking the sacrificial layer, for example with an FeCl₃ solution, so as to detach the membrane device, from the second substrate.

5. The process as claimed in one of the preceding claims, **characterized in that** the step of forming the nanowire device is implemented by molecular beam epitaxy or by metalorganic vapor-phase epitaxy or by etching.

6. The process as claimed in one of the preceding claims, **characterized in that** the forming step comprises forming the device so that it comprises a first substrate (2), the nanowires being placed on the first substrate, the nanowires especially being placed perpendicular or substantially perpendicular on a surface (21) of the first substrate, and/or so that the nanowires are prismatic or substantially prismatic and/or so that the nanowires have light-emitting-diode structures.

7. The process as claimed in one of the preceding claims, **characterized in that** the forming step comprises forming the receiving ends so that they form a planar or substantially planar discontinuous surface.

8. The process as claimed in the preceding claim, **characterized in that** the forming step comprises forming the device so that the ratio of the sum of the areas of the surfaces of the receiving ends to the continuous area of the surface of a membrane intended to make contact with the receiving ends is higher than 80% or higher than 90% or higher than 95%.

9. The process as claimed in one of the preceding claims, **characterized in that** the forming step comprises forming nanowires so that the nanowires have a geometry that increases in size or flares out in the direction of the receiving ends and/or **in that** the forming step comprises forming nanowires so that the nanowires form micro-pillars or nano-pillars including receiving ends the surfaces of which have dimensions larger than those of the diameters of the nanowires away from the receiving end.

10. The process as claimed in one of the preceding claims, **characterized in that** the forming step comprises forming nanowires so that they each comprise a body (11; 11') and a head (12; 12'), the head having a receiving end (13), the surface of the receiving end having an area 20% larger, or even 50% larger, than the area of a cross section (s) of the body of a nanowire, especially than the area of a cross section (s) of the nanowire measured parallel to the receiving end at at least 2 µm distance from the receiving end or than the area of a cross section (s) of the nanowire measured parallel to the receiving end in the middle of the nanowire.

11. The process as claimed in the preceding claim, **characterized in that** the forming step comprises forming the bodies of the nanowires into stacks of a layer (111) of n-type GaN, of a layer (112) of InGaN and of a blocking layer (113).

12. The process as claimed in one of claims 10 and 11, **characterized in that** the forming step comprises forming the heads of the nanowires into stacks of a layer (121) of p-type GaN and of a layer (122) of p⁺⁺-type GaN.

13. The process as claimed in one of claims 1 to 10, **characterized in that** the forming step comprises forming the nanowires from silicon-based material.
